(19) Europäisches Patentamt
European Patent Office
Office européen des brevets

(11) **EP 4 350 752 A2**

# EUROPEAN PATENT APPLICATION

(12)

(43) Date of publication:
**10.04.2024 Bulletin 2024/15**

(21) Application number: **23188980.9**

(22) Date of filing: **01.08.2023**

(51) International Patent Classification (IPC):
*H01L 21/822* (2006.01)     *H01L 21/8234* (2006.01)
*H01L 27/06* (2006.01)      *H01L 27/088* (2006.01)
*H01L 29/06* (2006.01)      *H01L 29/66* (2006.01)
*H01L 29/775* (2006.01)     *H01L 29/786* (2006.01)

(52) Cooperative Patent Classification (CPC):
**H01L 27/088; H01L 21/823412; H01L 21/823456;
H01L 21/823468; H01L 21/823481; H01L 29/0673;
H01L 29/66439; H01L 29/775; H01L 29/78696**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **07.10.2022 KR 20220128679**

(71) Applicant: **Samsung Electronics Co., Ltd.
Suwon-si, Gyeonggi-do 16677 (KR)**

(72) Inventors:
• **LIM, Sunme
16677 Suwon-si, Gyeonggi-do (KR)**
• **JEON, Joongwon
16677 Suwon-si, Gyeonggi-do (KR)**

(74) Representative: **Kuhnen & Wacker
Patent- und Rechtsanwaltsbüro PartG mbB
Prinz-Ludwig-Straße 40A
85354 Freising (DE)**

(54) **SEMICONDUCTOR DEVICE INCLUDING NANOSHEET TRANSISTOR**

(57) A semiconductor device may include a substrate including a first and a second row region, wherein a surface of the substrate is disposed in a first direction and a second direction perpendicular to the first direction, a first nanosheet structure (120) on the first row region and including active segments (21, 22, 23, 24) disposed in the first direction, and the active segments having different widths in the second direction; and a second nanosheet structure (122) on the second row region, the second nanosheet structure spaced apart from the first nanosheet structure in the second direction, and wherein the second nanosheet structure is symmetrical to the first nanosheet structure in the first direction. In a plan view, in each of the first and second nanosheet structures, transition regions between adjacent ones of the active segments have one of a same first angle and a second angle with respect to the first direction.

FIG. 1

## Description

CROSS-REFERENCE TO RELATED APPLICATION(S)

This application claims priority under 35 USC § 119 to Korean Patent Application No. 10-2022-0128679, filed on October 7, 2022, in the Korean Intellectual Property Office (KIPO), the contents of which are incorporated by reference herein in their entirety.

TECHNICAL FIELD

Embodiments relate to a semiconductor device and a manufacturing method thereof. More particularly, embodiments relate to a semiconductor device including a nanosheet transistor and a manufacturing method thereof.

DISCUSSION OF RELATED ART

Demand for miniaturization and improved performance of a semiconductor device has led to a nanosheet transistor. The nanosheet transistor may also be referred to with different names such as, nanobeam, nanoribbon, superimposed channel device, etc. The nanosheet transistor may be characterized by multiple nanosheet layers bridging source/drain electrodes formed at both ends thereof and a gate structure that wraps around the nanosheet layers. These nanosheet layers function as a channel structure for current flow between the source/drain electrodes of the nanosheet transistor. Due to this structure, improved control of current flow through the multiple nanosheet layers may be achieved in addition to higher device density in a semiconductor device including the nanosheet transistor.

In a nanosheet structure of the nanosheet transistor, variations in an alignment of the nanosheets may lead to defects in the structure.

SUMMARY

Example embodiments provide a semiconductor device having improved electrical characteristics.

According to example embodiments, there is provided a semiconductor device. The semiconductor device may include a substrate including a first row region and a second row region, wherein a surface of the substrate is disposed in a first direction and a second direction perpendicular to the first direction, a first nanosheet structure on the first row region, the first nanosheet structure including a plurality of active segments disposed in the first direction, and the plurality of active segments having different widths in the second direction; and a second nanosheet structure on the second row region, the second nanosheet structure spaced apart from the first nanosheet structure in the second direction, and wherein the second nanosheet structure is symmetrical with the first nanosheet structure in the first direction. In a plan view, in each of the first nanosheet structure and the second nanosheet structure, each of a plurality of transition regions between adjacent ones of the active segments have one of a same first angle and a second angle with respect to the first direction.

According to example embodiments, there is provided a semiconductor device. The semiconductor device may include a substrate including a surface disposed in a first direction and a second direction perpendicular to the first direction, a first nanosheet structure on the substrate, the first nanosheet structure including first active segments disposed in the first direction, and the first active segments having different widths in the second direction; a second nanosheet structure on the substrate, the second nanosheet structure including second active segments in the first direction and spaced apart from the first nanosheet structure in the second direction, and wherein the second nanosheet structure is symmetrical with the first nanosheet structure in the first direction; a diffusion break pattern extending in the second direction, the diffusion break pattern on contacting portions between the first active segments and the second active segments; and a gate structure extending in the second direction, the gate structure in a region between the diffusion break patterns. A plurality of protruding portions of the active segments included in the first nanosheet structure have a same width in the second direction.

According to example embodiments, there is provided a semiconductor device. The semiconductor device may include a first active structure including a first plurality of nanosheets having different widths in a second direction and first epitaxial patterns disposed between the first plurality of nanosheets in a first direction perpendicular to the second direction; a second active structure including a second plurality of nanosheets having different widths the a second direction and second epitaxial patterns disposed between the second plurality of nanosheets, the second active structure being symmetrical with the first active structure in the first direction, and the first plurality of nanosheets and the second plurality of nanosheets being spaced apart from each other in the second direction; and a gate structure extending in the second direction on the first plurality of nanosheets and the second plurality of nanosheets included in the first active structure and second active structure. A plurality of protruding portions of the first plurality of nanosheets protrude by a same width in the second direction.

In example embodiments, in the semiconductor device, defects of a multi-bridge channel transistor may be decreased.

BRIEF DESCRIPTION OF THE DRAWINGS

Example embodiments will be more clearly understood from the following detailed description taken in conjunction with the accompanying drawings. FIGS. 1 to 23 represent non-limiting, example embodiments as described herein.

FIG. 1 illustrates a designed layout of nanosheet structures of a standard cell in a semiconductor device according to example embodiments;

FIG. 2 illustrates nanosheet structures of a standard cell in a semiconductor device according to example embodiments;

FIG. 3 illustrates a design layout of nanosheet structures of a standard cell in a semiconductor device according to example embodiment;

FIG. 4 illustrates nanosheet structures of a standard cell in a semiconductor device according to according to example embodiment;

FIG. 5 illustrates a design layout of nanosheet structures of a standard cell in a semiconductor device according to example embodiment.

FIG. 6 illustrates nanosheet structures of a standard cell in a semiconductor device according to example embodiment;

FIG. 7 illustrates a designed layout of nanosheet structures of a standard cell in a semiconductor device for comparison;

FIG. 8 illustrates nanosheet structures of a standard cell in the semiconductor device shown in FIG. 7 for comparison;

FIGS. 9 to 21 are plan views, cross-sectional views, and perspective views illustrating a method of manufacturing a semiconductor device according to example embodiments;

FIG. 22 is a plan view illustrating first and second nanosheet stacks in a semiconductor device; and

FIG. 23 is a plan view illustrating a semiconductor chip according to example embodiments.

DETAILED DESCRIPTION

Hereinafter, preferred embodiments of the present invention will be described in detail with reference to the accompanying drawings.

Hereinafter, two directions substantially parallel to an upper surface of a substrate and substantially perpendicular to each other may be defined as a first direction and a second direction, respectively, and a direction substantially perpendicular to upper surface of the substrate may be defined as a vertical direction. Furthermore, two lines may be aligned when they form a same line.

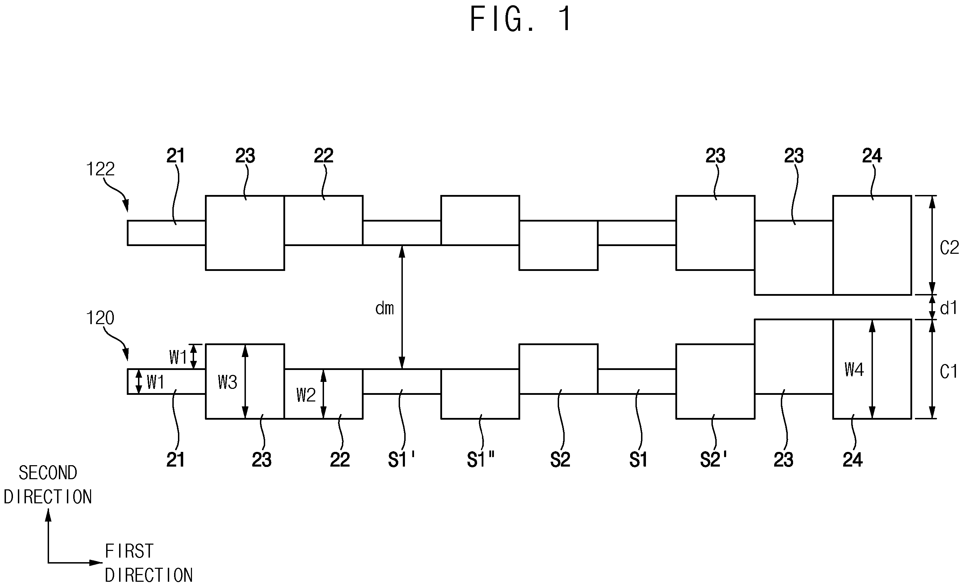

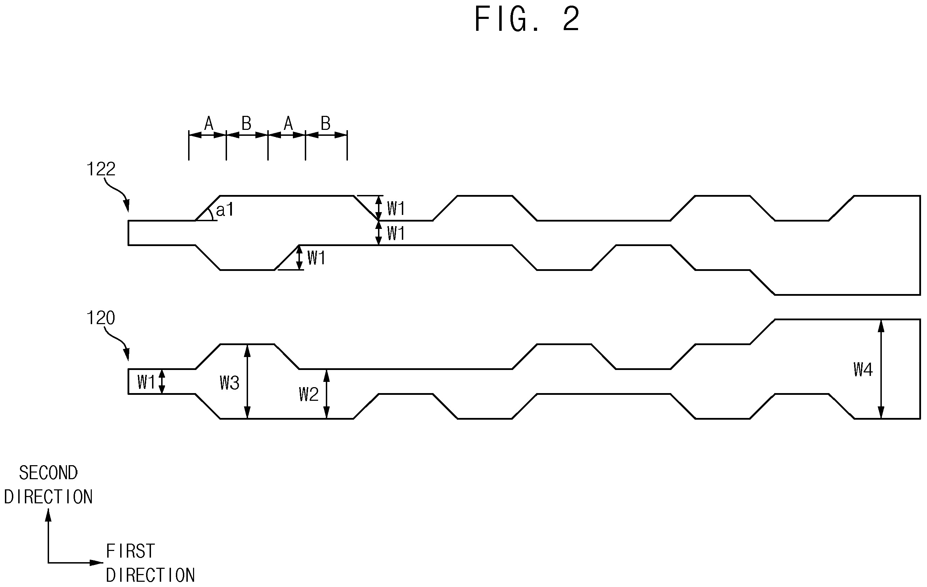

Herein, a "standard cell" may be understood as a group of transistors and interconnect structures that may provide a function. FIG. 1 illustrates a designed layout of nanosheet structures of a standard cell in a semiconductor device according to example embodiments. FIG. 2 illustrates nanosheet structures of a standard cell in a semiconductor device according to example embodiments. The nanosheet structures of FIG. 2 may be fabricated using a reticle pattern corresponding to the designed layout of FIG. 1.

FIGS. 1 and 2 are plan views of example embodiments corresponding to two rows R1 and R2 extending in the first direction in a standard cell.

Referring to FIG. 1, a first nanosheet structure 120 may be formed in a first row region C1, and the second nanosheet structure 122 may be formed in the second row region C2. The first nanosheet structure 120 and the second nanosheet structure 122 may be symmetrical with respect to the first direction.

Each of the first nanosheet structure 120 and the second nanosheet structure 122 may include semiconductor patterns spaced apart from each other in the vertical direction.

The first nanosheet structure 120 may include active segments 21, 22, 23, and 24. In the first nanosheet structure 120, the active segments 21, 22, 23, and 24 may be disposed in the first direction, and may be disposed in contact with each other. An arrangement of the active segments 21, 22, 23, and 24 may be substantially the same as a reticle pattern used in a photo process for forming the first nanosheet structure 120. Therefore, the first nanosheet structure 120 of FIG. 1 may be substantially the same as a plan view of the reticle pattern for forming a first nanosheet structure.

In example embodiments, the active segments 21, 22, 23, and 24 may have the same first length in the first direction. In some example embodiments, some of the active segments may have different lengths in the first direction. Each of the active segments 21, 22, 23, and 24 may have different widths in the second direction. Hereinafter, a width means a width in the second direction, a height in the second direction or a length in the second direction.

In example embodiments, the width of each of the active segments 21, 22, 23, and 24 may be a multiple (e.g., 1x, 2x, etc.) of a minimum width of the active segments included in the first nanosheet structure 120. For example, as illustrated in FIG. 1, the active segments may be divided into a first active segment 21, a second active segment 22, a third active segment 23, and a fourth active segment 24 according to the widths of the active segments. The first active segment 21 may have a first width W1 that is a minimum width. The second active segment 22 may have a second width W2 that is twice the width of the first width W1. The third active segment 23 may have a third width W3 that is three times the first width W1. The fourth active segment 24 may have a fourth width W4 that is four times the first width W1.

The first row region C1 may have a width substantially the same as a maximum width of the active segments 21, 22, 23, and 24 included in the first nanosheet structure 120. For example, as shown in FIG. 1, the first row region C1 may have the fourth width W4 of the fourth active segment 24.

Hereinafter, the first nanosheet structure 120 and the second nanosheet structure 122, including the first to fourth active segments 21, 22, 23, and 24, may be described. The number of active segments included in each of the first nanosheet structure 120 and the second nanosheet structure 122 may not be limited thereto.

In the first nanosheet structure 120, a boundary region where the active segments 21, 22, 23, and 24 contact each other and a region adjacent to the boundary region may serve as a transition region. Referring to FIG. 2, a transition region (A) of a first nanosheet structure 120 may have a slope, in the plan view. A diffusion break pattern (not shown) may be formed on the transition region (A) of the first nanosheet structure 120.

In an example embodiment, an arrangement of the active segments 21, 22, 23, and 24 included in the first nanosheet structure 120 may be provided so that defects in the transition region (A) may be decreased. Hereinafter, the arrangement of the active segments 21, 22, 23, and 24 included in the first nanosheet structure 120 may be described in more detail.

Widths in the second direction of two active segments in contact with each other may be the same as or different from each other. In this case, a difference between the widths of the two active segments in contact with each other may be equal to or less than twice the first width W1. For example, since the difference between the width of the first active segment 21 and the width of the fourth active segment 24 may be three times of the first width, the first active segment 21 and the fourth active segment 24 may not be disposed in contact with each other. For example, since the difference between the width of the first active segment 21 and the width of the third active segment 23 may be twice the first width, the first active segment 21 and the third active segment 23 may be disposed in contact with each other.

In the plan view, a reference active segment and neighboring active segments contacting the reference active segment may be provided, and one or more of the neighboring active segments may have a width greater than a width of the reference active segment. In this case, a neighboring active segment may protrude from at least one of an upper side and a lower side of the reference active segment.

For example, the neighboring active segment (e.g., S2) may protrude from the upper side of the reference active segment (e.g., S1). The neighboring active segment S2 may not protrude from the lower side of the reference active segment S1 and may extend in the first direction. For another example, the neighboring active segment (e.g., S1") may protrude from the lower side of the reference active segment (e.g., S1'). The neighboring active segment S1"may not protrude from the upper side of the reference active segment S1' and may extend in the first direction. For another example, the neighboring active segment (e.g., S2') may protrude from the upper and lower sides of the reference active segment (e.g., S1).

As described above, the reference active segment and neighboring active segments may be disposed in the first nanosheet structure 120. Therefore, due to differences in the widths of adjacent active segments forming the upper side and the lower side of the first nanosheet structure 120, the upper side and the lower side may have widths that may not be aligned in the first direction.

A width of a protruding portion of the neighboring active segment protruding from the upper side and/or the lower side of the reference active segment may be equal to the first width W1. When the adjacent active segments have protruding portions in the second direction, all widths of protruding portions in the second direction in adjacent active segments may have a width the same as the first width W1.

In the plan view, in the first nanosheet structure 120, one reference active segment S1" and at least one of the neighboring active segments, for example, neighboring active segment S2, adjacent to the reference active segment S1" may have the same width.

In example embodiments, as shown in FIG. 1, the neighboring active segment (e.g., S2) may protrude from one of upper and lower sides of the reference active segment (e.g., S1"). The width of the protruding portion of the neighboring active segment may be the same as the first width W1. Therefore, in the first nanosheet structure 120, any active segment adjacent to two active segments may protrude from at least one of the upper side and the lower side of at least one of the adjacent active segments.

As described above, in the first nanosheet structure 120, any active segment may protrude from one or both of the upper side and the lower side of any of the adjacent active segment in the second direction. Further, in the first nanosheet structure 120, any active segment may protrude from the upper side or the lower side of any adjacent active segment without protruding portion from the other side. When the adjacent active segments have protruding portions in the second direction, all widths of the protruding portions in the second direction may be the first width W1. Some of the adjacent active segments may have no protruding portion, in this case, the upper sides of the adjacent active segments may be aligned and the lower sides of the adjacent active segments may be aligned, such that there are no protruding portions between the adjacent active segments.

When the first nanosheet structure 120 may be patterned using a reticle pattern including the active segments having the arrangement of FIG. 1, as shown in FIG. 2, the protruding portions in adjacent active segments may be formed to have a slope between adjacent upper sides or adjacent lower sides. In an embodiment, the slope may not be an angle of 90 degrees. That is, the transition region (A) of a first nanosheet structure 120 may have the slope of about 45 degrees.

Referring to FIG. 2, since all the protruding portions may have the same first width W1, the transition regions (A) of the first nanosheet structure 120 may have the same slope, which is a first slope. The adjacent active segments may have no protruding portion, so that the transition regions (A) of the first nanosheet structure 120 may have no slope. For example, the upper sides and the lower sides of the adjacent active segments may be aligned, such that there are no protruding portions between the adjacent active segments. Accordingly, the transition regions of the first nanosheet structures 120 may have a first angle a1 with respect to the first direction or may have an angle of 0 degrees with respect to the first direction.

In the plan view, a first side (e.g., the upper side) of the first nanosheet structure 120 may not form a straight line extending in the first direction. Similarly, a second side (e.g., the lower side) of the first nanosheet structure 120 opposite the first side may not form a straight line extending in the first direction. That is, each of the first side and the second side of the first nanosheet structure 120 may be formed of active segments having different widths in the second direction and different alignments in the first direction.

Since the first nanosheet structure 120 and the second nanosheet structure 122 are symmetrical with respect to the first direction, the second nanosheet structure 122 may have a shape substantially the same as a shape of the first nanosheet structure 120.

The second row region C2 corresponding to the second nanosheet structure 122 may be spaced apart from the first row region C1 corresponding to the first nanosheet structure 120 by a first distance d1 in a second direction. The second row region C2 may have a width substantially the same as a width of the first row region C1.

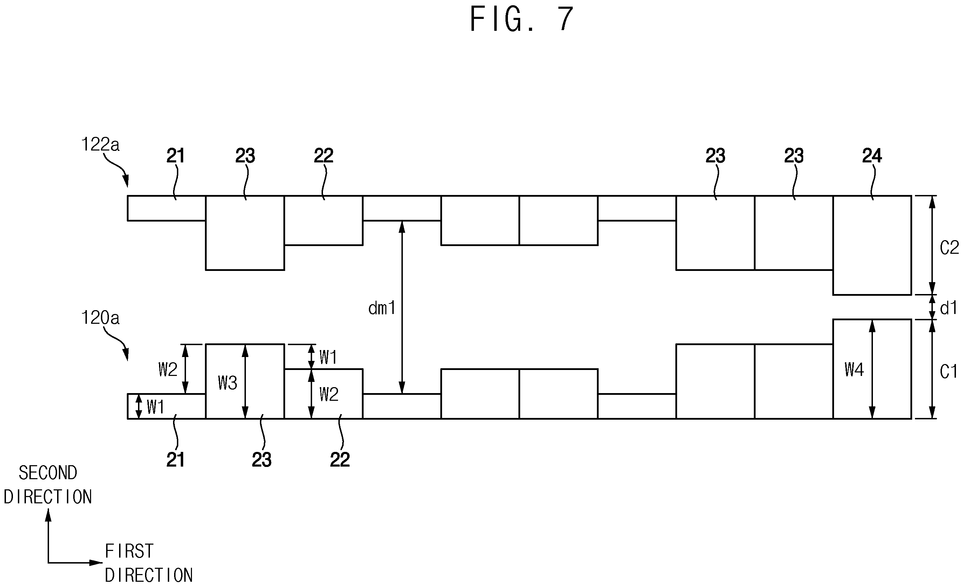

In an example where opposing sides of the first nanosheet structure 120 and the second nanosheet structure 122 may not form a straight line extending in the first direction, a maximum distance (dm) in the second direction between the first nanosheet structure 120 and the second nanosheet structure 122 may be decreased as compared to a case where one side of each of the first and second nanosheet structure are formed in a straight line extending in the first direction (see for example, FIG. 7).

In example embodiments, the maximum distance (dm) in the second direction between the first nanosheet structure 120 and the second nanosheet structure 122 may be equal to or less than a sum of twice a difference between the maximum width (e.g., the fourth width, W4) and the minimum width (e.g., the first width, W1) and the first distance d1. Stated another way the maximum distance (dm) may be determined as:

$$dm = (2(W4\text{-}W1)) + d1.$$

For example, as shown in FIG. 1, the maximum width (e.g., the fourth width, W4) of the active segments may be an even multiple of the minimum width (e.g., the first width, W1). A maximum distance (dm) in the second direction between the first nanosheet structures 120 and the second nanosheet structure 122 may be the sum of the maximum step difference of the active segments and the first distance d1. For example, in FIG. 1, the maximum width (dm) may be determined as:

$$dm = W1\text{+}W1\text{+}W1\text{+}W1\text{+}d1,$$

where the maximum step difference of the active segments for each of the nanosheet structures is W1+W1 and the maximum step difference of the active segments for both nanosheet structures is W1+W1+W1+W1.

Therefore, the distance in the second direction between the first nanosheet structure 120 and the second nanosheet structure 122 may be decreased.

A diffusion break pattern (not shown) extending in the second direction may be formed in each of the transition regions A of the first nanosheet structure 120 and the second nanosheet structure 122. A gate structure (not shown) extending in the second direction may be formed in a regions B between the transition regions of the first nanosheet structure 120 and the second nanosheet structure 122, and the gate structure may cross both the first nanosheet structure 120 and the second nanosheet structure 122.

The first nanosheet structure 120 and the second nanosheet structure 122 may be formed on at least a portion of the semiconductor device.

As such, the active segments included in the first nanosheet structure 120 and the second nanosheet structure 122 may be arranged according to the above-description. Hereinafter, examples of the arrangements of active segments in the first nanosheet structure 120 may be described.

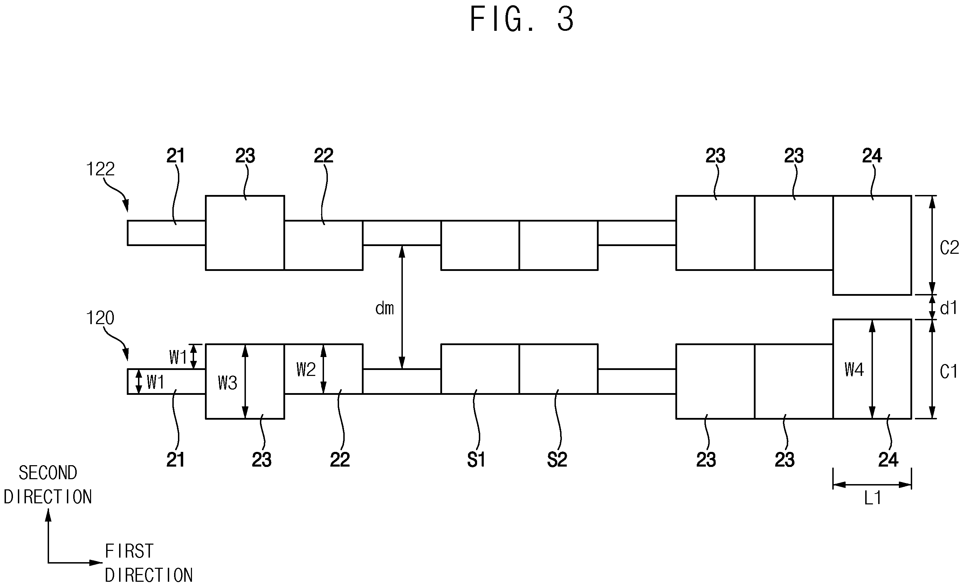

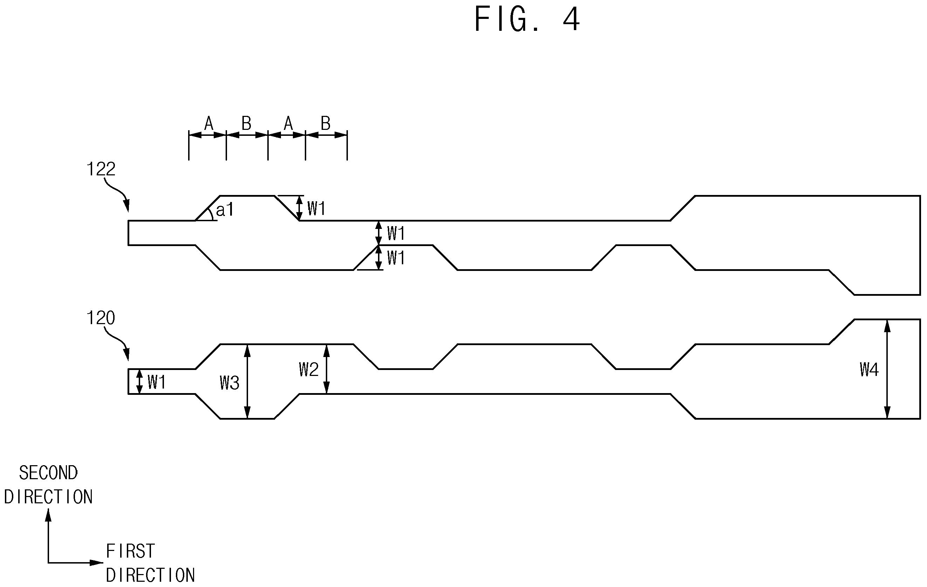

FIG. 3 illustrates a design layout of nanosheet structures of a standard cell in a semiconductor device according to example embodiment. FIG. 4 illustrates a layout of nanosheet structures of a standard cell in a semiconductor device according to according to example embodiment. The nanosheet structures of FIG. 4 may be fabricated using a reticle pattern corresponding to the designed layout of FIG. 3.

The nanosheet structures in FIGS. 3 and 4 may include active segments similar to the active segments of the nanosheet structures described in FIGS. 1 and 2.

Referring to FIG. 3, in the first nanosheet structure 120, a difference between widths of adjacent active segments may be equal to or less than twice the first width W1. For example, a width of active segment 23, having a third width W3, is greater than a width of active segment 21 having a first width W1, which may be the maximum difference between widths of adjacent active segments.

In a plan view, a reference active segment and neighboring active segments contacting the reference active segment may be provided. In some embodiments, one or more of the neighboring active segments may have a width greater than a width of the reference active segment. In this case, the neighboring active segment may protrude from at least one of an upper side and a lower side of the reference active segment. When the adjacent active segments have protruding portions in the second direction, all the widths of the protruding portions may have the same width, that is the first width W1. For example, a step difference between adjacent active segments may be W1 or 0.

In a plan view, a reference active segment S1 and a neighboring active segment S2 contacting the reference active segment S1 may be provided, and the neighboring active segment S2 may have a width that is the same as a width of the reference active segment S1. In this case, the reference active segment S1 and the neighboring active segment S2 may be aligned in the first direction. That is, the neighboring active segment S2 may not protrude from the upper or lower sides of the reference active segment S1.

As described above, when the adj acent active segments have protruding portions in the second direction, all the widths of protruding portions of adjacent active segments may have a width the same as the first width W1. Some of the adjacent active segments may have no protruding portion in the second direction, in this case, the upper sides of the adjacent active segments may be aligned and the lower sides of the adjacent active segments may be aligned, such that there are no protruding portions between the adjacent active segments. The second nanosheet structure 122 may be symmetrical to the first nanosheet structure 120 in the first direction.

As shown in FIG. 4, in the first nanosheet structure 120 formed by using the reticle pattern including the active segments having the arrangement of FIG. 3, contacting portions of the adjacent active segments may have the same first slope. In the first nanosheet structure 120, the adjacent active segments having no protruding portion may have no slope. Accordingly, all of transition regions of the first nanosheet structures 120 may have the same first angle, a1, with respect to the first direction or may have an angle of 0 degrees with respect to the first direction.

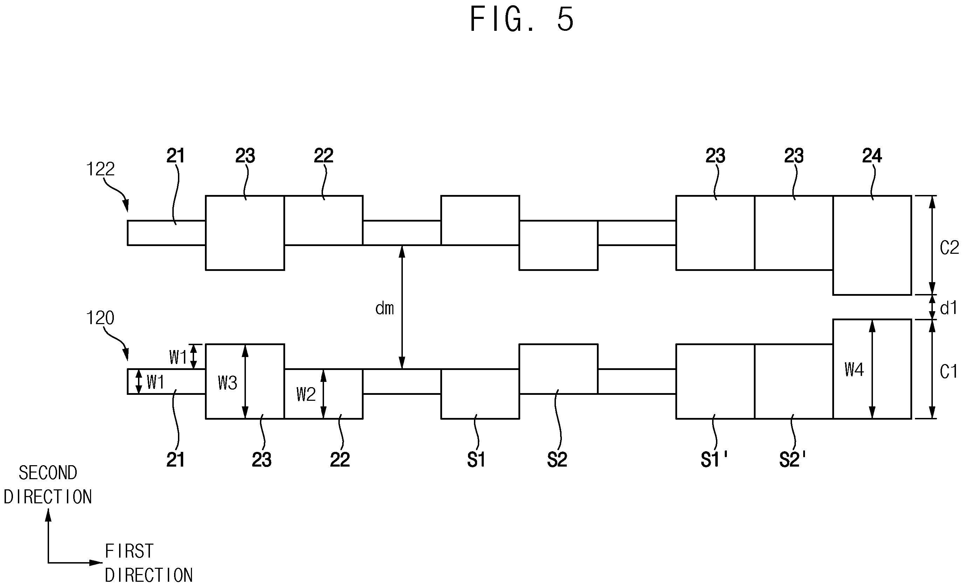

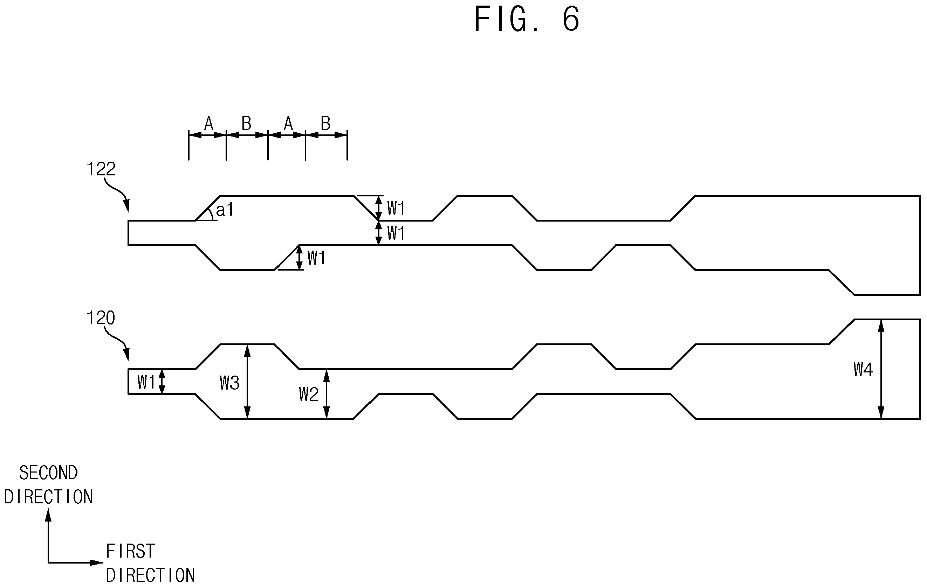

FIG. 5 illustrates a design layout of nanosheet structures of a standard cell in a semiconductor device according to example embodiment. FIG. 6 illustrates a layout of nanosheet structures of a standard cell in a semiconductor device according to example embodiment. The nanosheet structures of FIG. 6 may be fabricated using a reticle pattern corresponding to the designed layout of FIG. 5.

The nanosheet structures in FIGS. 5 and 6 may include a same number of active segments as the nanosheet structures described in FIGS. 1 and 2.

Referring to FIG. 5, in the first nanosheet structure 120, a difference between widths of adjacent active segments may be equal to or less than twice the first width W1.

In the plan view, a reference active segment and neighboring active segments contacting the reference active segment may be provided. One or more of the neighboring active segments may have a width greater than a width of the reference active segment. In this case, the neighboring active segment may protrude from at least one of an upper side and a lower side of the reference active segment. When the adjacent active segments have protruding portions in the second direction, all the protruding portions in the second direction may have the same width, that is the first width W1.

In the plan view, a reference active segment S1 and a neighboring active segment S2 adjacent to the reference active segment S1 may be provided. The neighboring active segment S2 may have a width the same as a width of the reference active segment S1 and the reference active segment S1 and the neighboring active segment S2 may be unaligned. In this case, the neighboring active segment S2 may protrude from one of the upper side and the lower side of the reference active segment S1. A width of a portion protruding in the second direction of the neighboring active segment S2 protruding from the upper side or lower side of the reference active segment S1 may have the first width W1. A second reference active segment S1' and a second neighboring active segment S2' may be aligned in the first direction. That is, the second neighboring active segment S2' may not protrude from the upper side or the lower side of the second reference active segment S1'.

As described above, when the adj acent active segments have protruding portions in the second direction, all the widths of protruding portions in the second direction may have the same width, that is the first width W1. Some of the adjacent active segments may have no protruding portion in the second direction, in this case, and the adjacent active segments may be aligned.

The second nanosheet structure 122 may be symmetrical to the first nanosheet structure 120 in the first direction.

As shown in FIG. 6, in the first nanosheet structure 120 formed by using the reticle pattern including the active segments having the arrangement of FIG. 5, contacting portions of the adjacent active segments may have the same first slope. In the first nanosheet structure 120, the adjacent active segments having no protruding portion may have no slope. Accordingly, all the transition regions (A) of the first nanosheet structures 120 may have the same first angle, a1, with respect to the first direction or may have an angle of 0 degrees with respect to the first direction.

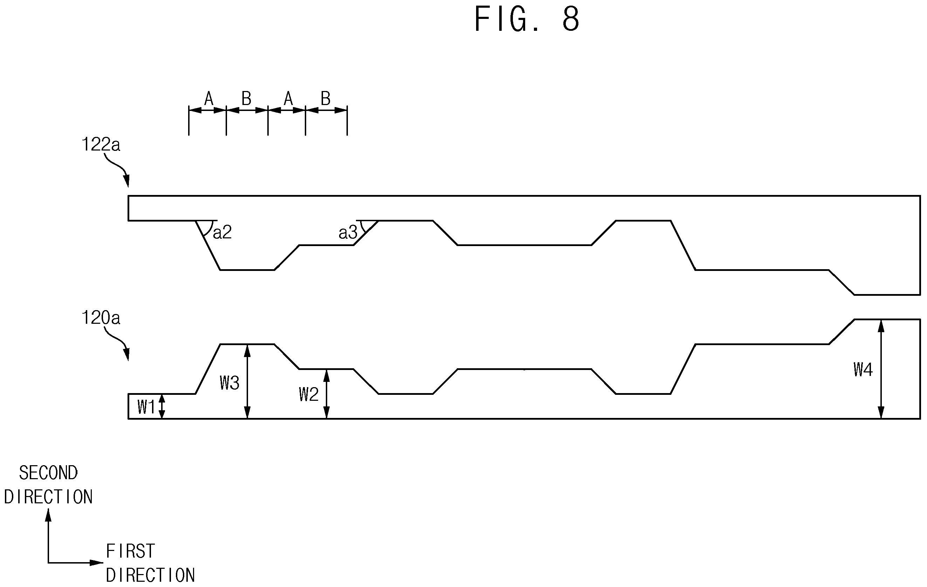

FIG. 7 illustrates a designed layout of nanosheet structures of a standard cell in a semiconductor device for comparison. FIG. 8 illustrates a layout of nanosheet structures of a standard cell in the semiconductor device shown in FIG. 7 for comparison. The nanosheet structures of FIG. 8 may be fabricated using a reticle pattern corresponding to the designed layout of FIG. 7.

The nanosheet structures in FIGS. 7 and 8 may include a same number of active segments as the nanosheet structures described in FIGS. 1 and 2.

Referring to FIG. 7, the active segments 21, 22, 23, and 24 may be arranged so that one of the upper side and the lower side of the first nanosheet structure 120a may be aligned in the first direction, with no step difference in the second direction. In example embodiments, the lower sides of the active segments of the first nanosheet structure 120a may be aligned in the first direction. The upper sides of the active segments of the second nanosheet structure 122a may be aligned in the first direction.

In this case, in the plan view, widths of protruding portions in the second direction in a reference active segment and a neighboring active segment contacting the reference active segment may not be the same to each other. For example, widths of the protruding portions in the second direction may have the first width W1 or the second width W2, wherein a width of the second width W2 is two times the width of the first width W1.

A maximum distance (dm1) in the second direction between the first nanosheet structure 120a and the second nanosheet structure 122a may be a sum of twice a difference between a maximum width (e.g., the fourth width, W4) of active segments included in each of the first nanosheet structure 120a and the second nanosheet structure 122a and the minimum width (e.g., the first width, W 1) of active segments included in each of the first nanosheet structure 120a and the second nanosheet structure 122a, and the first distance, d1. Therefore, the maximum distance (dm1) in the second direction between the first nanosheet structure 120a and the second nanosheet structure 122a according to example for comparison may be greater than the maximum distance (dm) in the second direction between the first nanosheet structure 120 and the second nanosheet structure 122 according to example embodiments described herein.

As shown in FIG. 8, in the first nanosheet structure 120 formed by using the reticle pattern including the active segments having the arrangement of FIG. 7, contacting portions of the adjacent active segments may have different slopes. Accordingly, the transition regions of the first nanosheet structure 120s may have a first angle, a1, with respect to the first direction, a second angle, a2, different than the first angle, a1, with respect to the first direction or may have an angle of 0 degrees with respect to the first direction.

Hereinafter, a method of manufacturing a semiconductor device including nanosheet structures in a standard cell may be described according to example embodiments.

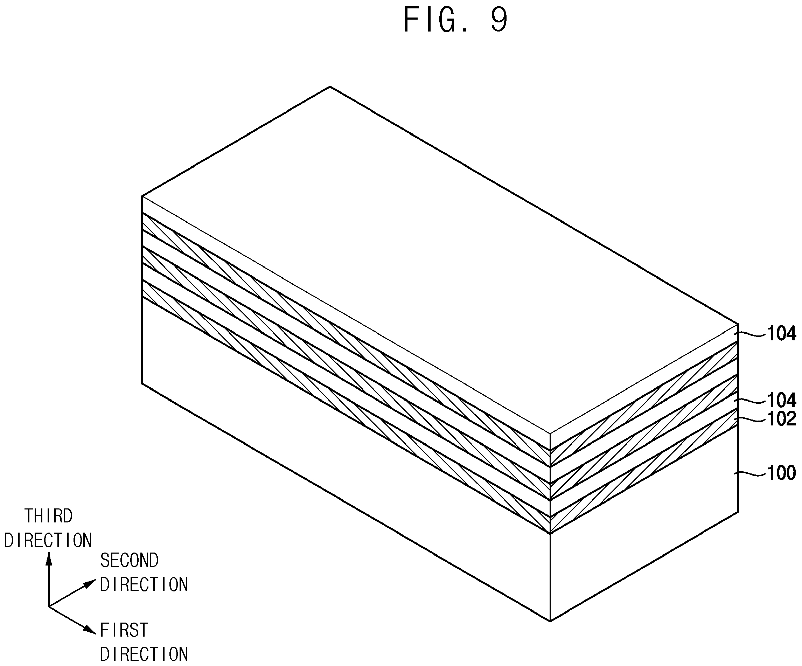

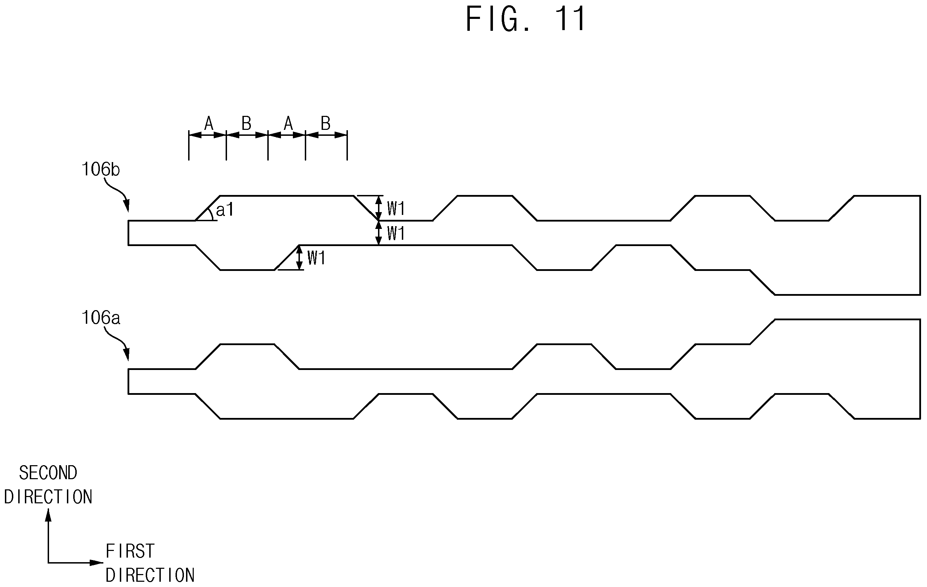

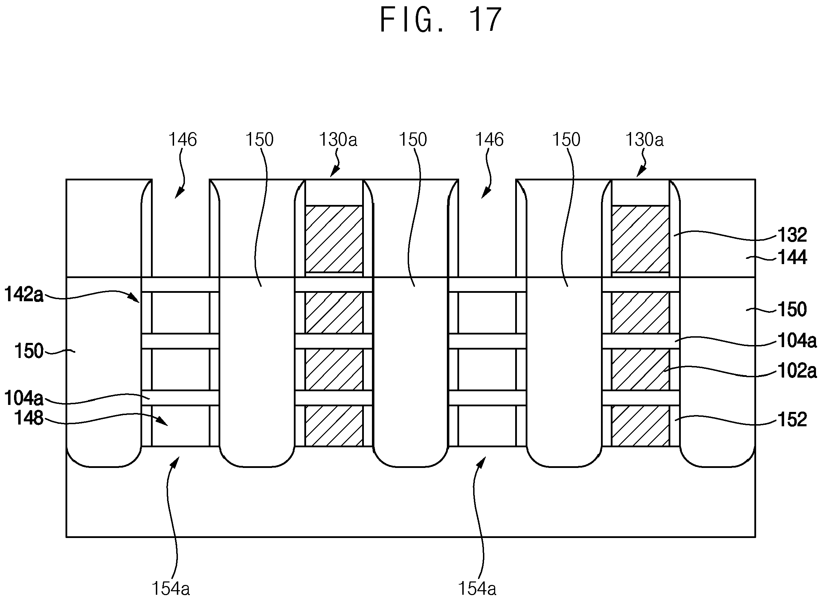

FIGS. 9 to 21 are plan views, cross-sectional views, and perspective views illustrating a method of manufacturing a semiconductor device according to example embodiments. More particularly, FIGS. 9, 10 and 12 are perspective views, FIGS. 11, 13 to 16, 18 and 20 are plan views, and FIGS. 17, 19 and 21 are cross-sectional views.

Referring to FIG. 9, a silicon germanium layer 102 and a silicon layer 104 may be alternately and repeatedly stacked on a substrate 100. The substrate 100 may be a single crystal silicon substrate. The silicon germanium layer 102 and the silicon layer 104 may be formed by, for example, a selective epitaxial growth process. A lowermost silicon germanium layer may be formed by a selective epitaxial growth process using an upper portion of the substrate 100 as a seed layer.

In example embodiments, the silicon layer 104 may be formed by performing a selective epitaxial growth process using a silicon source gas such as disilane (Si2H6) gas. The silicon layer 104 may include single crystal silicon.

In example embodiments, the silicon germanium layer 102 may be formed by a selective epitaxial growth process using a silicon source gas such as dichlorosilane (SiH2Cl2) gas and a germanium source gas such as germanium tetrahydrogen (GeH4) gas. The silicon germanium layer 102 may include, for example, single crystal silicon germanium.

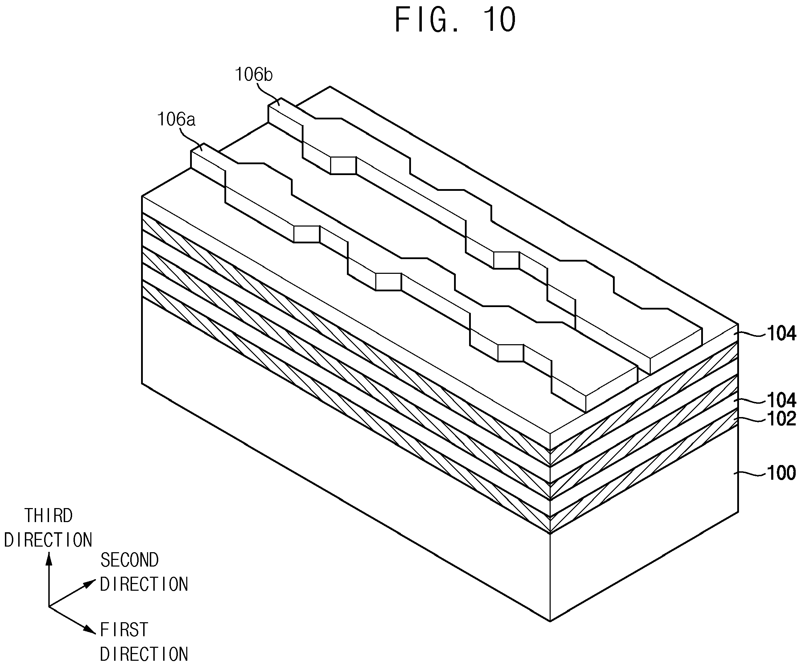

Referring to FIGS. 10 and 11, a mask layer may be formed on the silicon layer 104 that is uppermost in the stack. The mask layer may be patterned by a photolithography process to form first mask pattern 106a and second mask pattern 106b on the silicon layer 104 that is uppermost in the stack.

The mask layer may include, e.g., a nitride such as silicon nitride. The first mask pattern 106a and second mask pattern 106b may extend in the first direction. The first mask pattern 106a and second mask pattern 106b may be symmetrical to each other with respect to the first direction.

In a photo process for patterning the mask layer, a designed reticle pattern according to example embodiments may be used. For example, the reticle pattern may have a shape as shown in of FIGS. 1, 3 or 5.

FIG. 11 is a plan view of first mask pattern 106a and second mask pattern 106b formed by using the reticle pattern shown in FIG. 1.

As shown in FIG. 11, in the plan view, when the adjacent active segments have protruding portions in the second direction, all widths of protruding portions in the second direction in adjacent active segments of the reticle pattern may have the same width, that is the first width W1. The adjacent active segments may have no protruding portion, in this case, the adjacent active segments may be aligned and the width of the protruding portion in the second direction may be zero. In addition, an upper side and a lower side of each of the first mask pattern 106a and the second mask pattern 106b may not form straight lines in the first direction.

When the first mask pattern 106a and the second mask pattern 106b are formed, the protruding portions in the second direction in adjacent active segments may have a first slope lower than an angle of 90 degrees. In this case, since the protruding portions in the second direction have the same width, that is the first width W1, the protruding portions of the first mask pattern 106a and the second mask pattern 106b have the same angle with respect to the first direction.

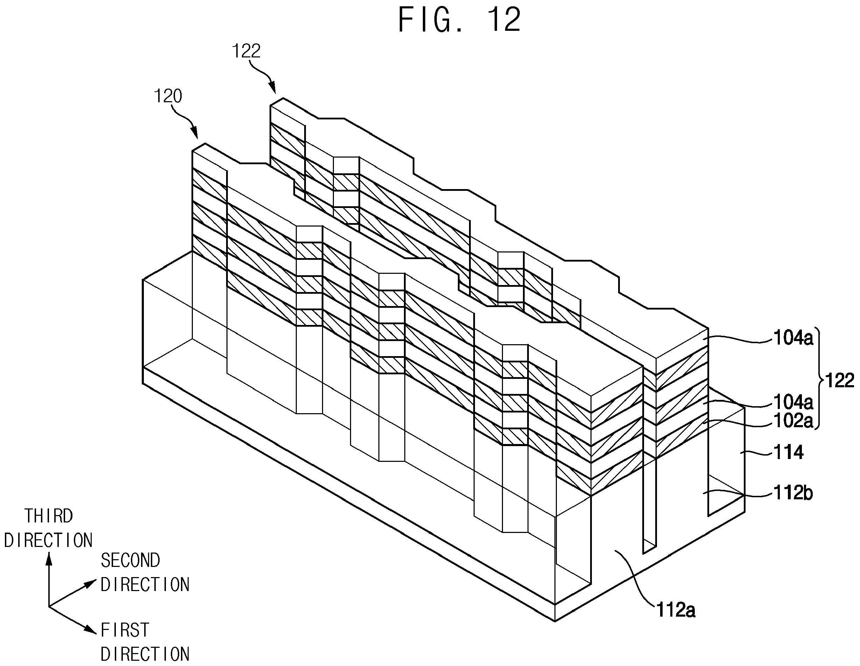

Referring to FIG. 12, the silicon germanium layer 102, the silicon layer 104, and an upper portion of the substrate 100 may be etched using the first mask pattern 106a and the second mask pattern 106b as an etching mask to form a first trench. The etching process may include, for example, an anisotropic etching process.

The substrate 100 may be etched to form first lower active pattern 112a and second lower active pattern 112b extending in the first direction. A first nanosheet structure 120 including first silicon germanium patterns 102a and first silicon patterns 104a being alternately and repeatedly stacked may be formed on the first lower active pattern 112a. A second nanosheet structure 122 including first silicon germanium patterns 102a and first silicon patterns 104a being alternately and repeatedly stacked may be formed on the second lower active pattern 112b.

Since the first nanosheet structure 120 and the second nanosheet structure 122 are patterned by using the first mask pattern 106a and the second mask pattern 106b as etching masks, the first mask pattern 106a and the second mask pattern 106b may have the same shape. For example, the first nanosheet structure 120 and the second nanosheet structure 122 may have shapes as shown in FIGS. 2, 4, or 6.

In the first nanosheet structure 120 and the second nanosheet structure 122, an interface between the protruding portions of the first mask pattern 106a and the second mask pattern 106b may correspond to a transition region. Accordingly, the transition regions of the first nanosheet structure 120 and the second nanosheet structure 122 may have a slope of the same angle.

Thereafter, an isolation layer may be formed to fill the first trench. An upper portion of the isolation layer may be etched to form an isolation pattern 114 in the first trench. The isolation pattern 114 may cover sidewalls of the first lower active pattern 112a and the second lower active pattern 112b. The first mask pattern 106a and the second mask pattern 106b may be removed. The first nanosheet structure 120 and the second nanosheet structure 122 may be formed between the isolation patterns 114, and may protrude from the isolation patterns 114.

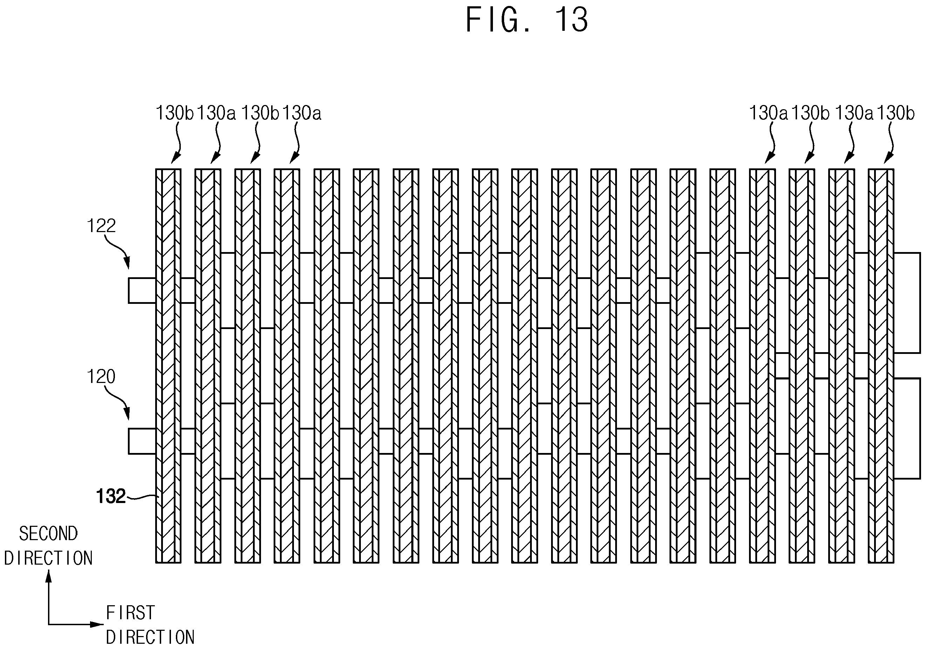

Referring to FIG. 13, dummy gate structures 130a and 130b may be formed to partially cover the isolation pattern 114 and the first nanosheet structure 120 and the second nanosheet structure 122. The dummy gate structures 130a and 130b may extend in the second direction. The dummy gate structures 130a and 130b may cross the first nanosheet structure 120 and the second nanosheet structure 122. A first spacer 132 may be formed on sidewalls of the dummy gate structures 130a and 130b.

The dummy gate structures 130a and 130b may be formed to be spaced apart from each other in the first direction. In example embodiments, the dummy gate structures 130a and 130b may have the same width in the first direction. Each of the dummy gate structures 130a and 130b may be spaced apart by equal intervals in the first direction.

The dummy gate structures 130a and 130b may be disposed on positions where a gate structure and a diffusion break pattern may be subsequently formed. The dummy gate structure 130a disposed on the transition region of the first nanosheet structure 120 and the second nanosheet structure 122 may be replaced with a diffusion break pattern by subsequent processes. The dummy gate structure 130b disposed on a region other than the transition region of the first nanosheet structure 120 and the second nanosheet structure 122 may be replaced with a gate structure by subsequent processes. Hereinafter, the dummy gate structure disposed on the transition region of the first nanosheet structure 120 and the second nanosheet structure 122 may be referred to as a first dummy gate structure 130a. The dummy gate structure disposed on the region other than the transition region of the first and second nanosheet structures may be referred to as a second dummy gate structure 130b.

In the plan view, the transition regions of each of the first nanosheet structure 120 and the second nanosheet structure 122 may have a slope of the same angle. Therefore, the first spacer 132 may be uniformly formed on the sidewall of the dummy gate structure on the transition regions of each of the first nanosheet structure 120 and the second nanosheet structure 122.

Although not shown, each of the dummy gate structures 130a and 130b may include, for example, a dummy gate insulation pattern, a dummy gate electrode, and a dummy gate mask pattern.

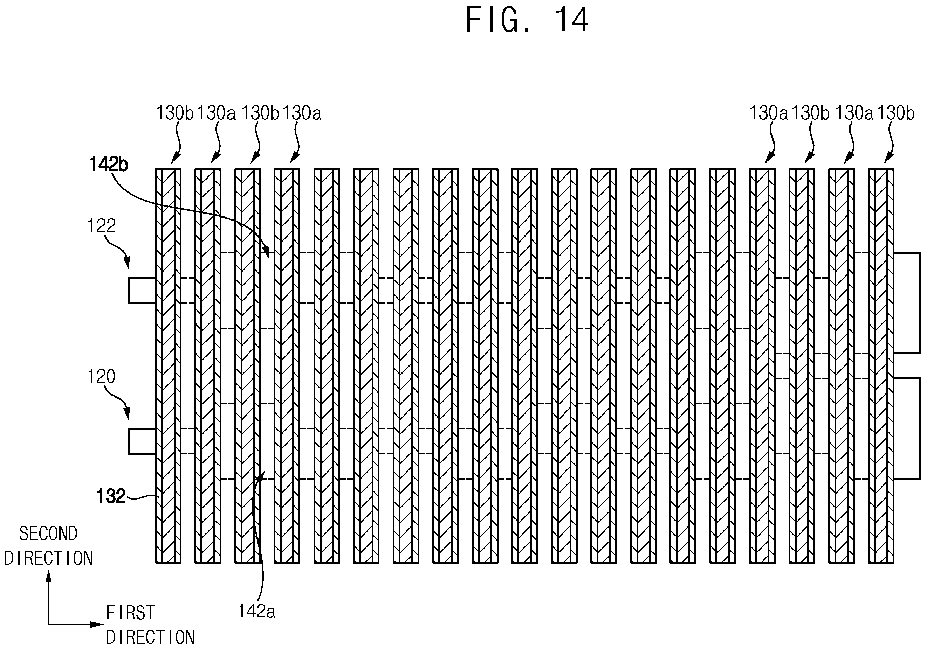

Referring to FIG. 14, the first nanosheet structure 120 between the dummy gate structures 130a and 130b may be removed to form first openings 142a. The second nanosheet structure 122 between the dummy gate structures 130a and 130b may be removed to form second openings 142b. That is, the first openings 142a and the second openings 142b may be formed between the first spacer 132.

First lower active pattern 112a and the second lower active pattern 112b may be exposed by bottom surfaces of the first openings 142a and the second openings 142b, respectively.

As the first spacers 132 are uniformly formed on the sidewalls of the dummy gate structures 130a and 130b, the first nanosheet structure 120 and the second nanosheet structures 122 between the dummy gate structures 130a and 130b may be uniformly removed to form the first openings 142a and the second openings 142b. The first openings 142a and the second openings 142b may have a uniform depth. Also, the first openings 142a and the second openings 142b may be formed to have target sidewall profiles.

Although not shown, in example embodiments, after forming the first openings 142a and second openings 142b, exposed sidewalls of the first silicon germanium pattern 102a may be partially etched to form a recess. An inner spacer 152 (see FIG. 17) may be further formed in the recess.

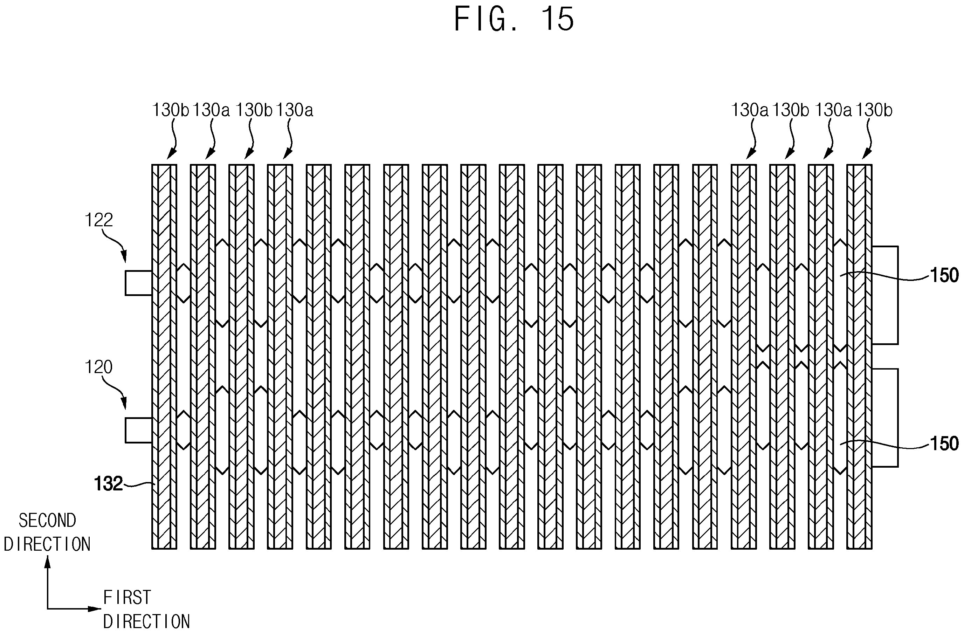

Referring to FIG. 15, epitaxial patterns 150 may be formed in the first openings 142a and the second openings 142b by performing a selective epitaxial growth process. The epitaxial patterns 150 may include a semiconductor material.

In example embodiments, an N-type multibridge channel transistor may be formed on each of the first nanosheet structure 120 and the second nanosheet structure 122. In this case, each of the epitaxial patterns 150 may include single crystal silicon. In some example embodiments, a P-type multi-bridge channel transistor may be formed on each of the first nanosheet structure 120 and the second nanosheet structure 122. In this case, each of the epitaxial patterns 150 may include single crystal silicon germanium. In some example embodiments, a P-type multi-bridge channel transistor may be formed on one of the first nanosheet structure 120 and the second nanosheet structure 122, and an N-type multibridge channel transistor may be formed on the other one of the first nanosheet structure 120 and the second nanosheet structure 122.

In example embodiments, impurities may be doped in situ during the selective epitaxial growth process. Accordingly, the epitaxial pattern 150 may serve as source/drain regions of multi-bridge channel transistors that may be subsequently formed.

In the selective epitaxial growth process, crystal growth may be performed in the vertical direction from the first lower active pattern 112a and the second lower active pattern 112b on the bottom surfaces of the first openings 142a and the second openings 142b. In the selective epitaxial growth process, crystal growth may also be performed in the second direction. Accordingly, each of the epitaxial patterns 150 may have a polygonal shape with a central protruding portion in the second direction, in a cross-sectional view.

As depths and sidewall profiles of the first openings 142a and the second openings 142b are uniformly formed, the epitaxial pattern 150 in each of the first openings 142a and the second openings 142b may have a target volume.

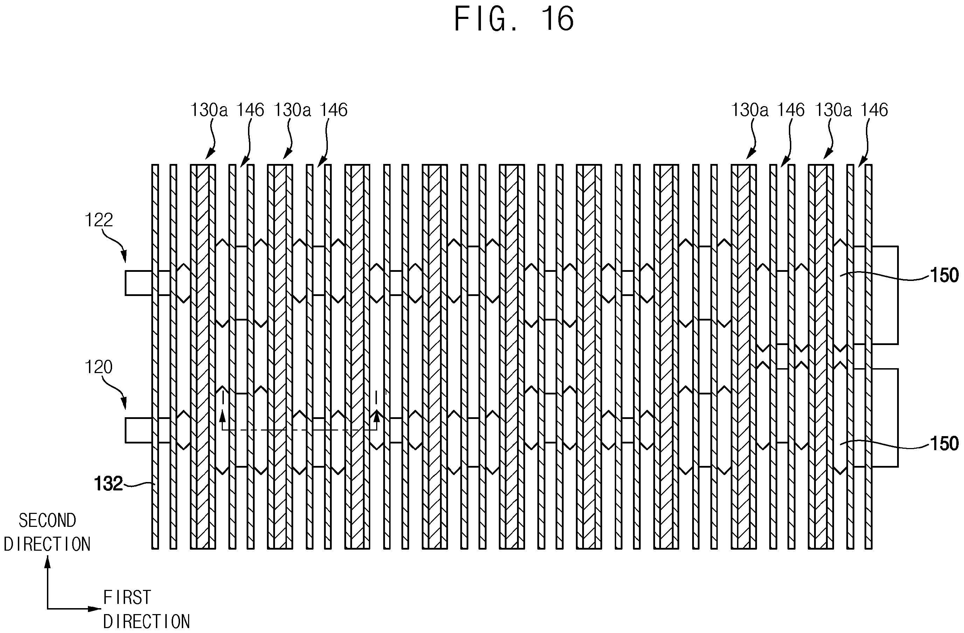

FIGS. 17, 19, and 21 are cross-sectional views illustrating a portion of a semiconductor device. Hereinafter, embodiments may be described with reference to FIGS. 17, 19, and 21 together. FIGS. 17, 19, and 21 are cross-sectional views taken along line I-I' of FIG. 16.

Referring to FIGS. 16 and 17, an insulating interlayer 144 may be formed to cover the epitaxial pattern 150, the isolation pattern 114 (see FIG. 13) and the dummy gate structures 130a and 130b. Thereafter, the insulating interlayer 144 may be planarized until upper surfaces of the dummy gate structures 130a and 130b may be exposed.

The second dummy gate structures 130b may be removed to form a first gate trench 146. The first silicon germanium patterns in the first nanosheet structure 120 and the second nanosheet structure 122 exposed by the first gate trench 146 may be selectively removed to form gaps 148 between the first silicon patterns 104a.

The first silicon patterns 104a spaced apart from each other in the vertical direction formed from the first nanosheet structures 120 and the second nanosheet structure 122 may form a first nanosheet stack 154a and a second nanosheet stack (not shown), respectively. The first and second nanosheet stacks may include the gaps 148 between the first silicon patterns 104a.

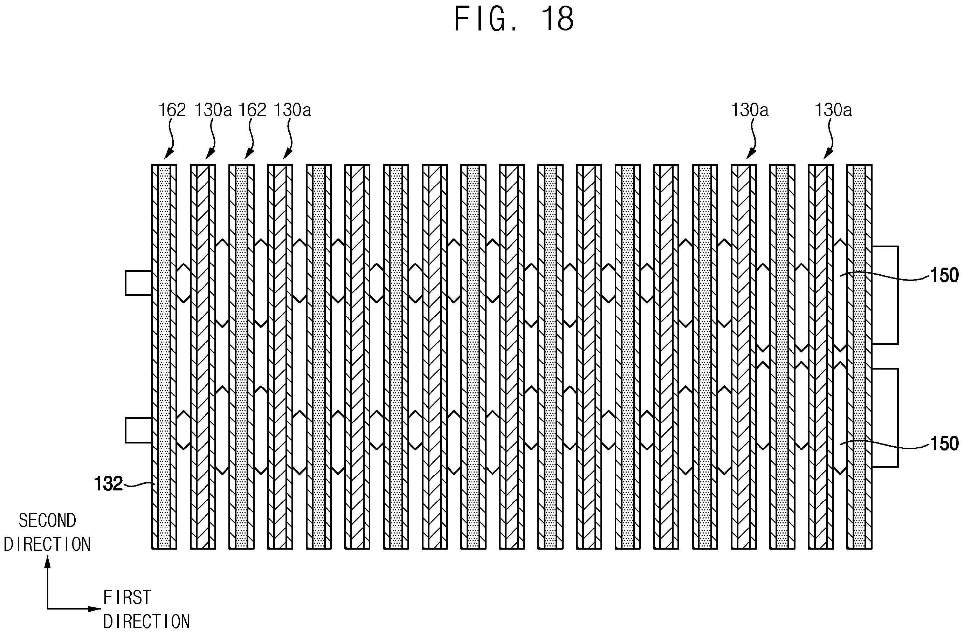

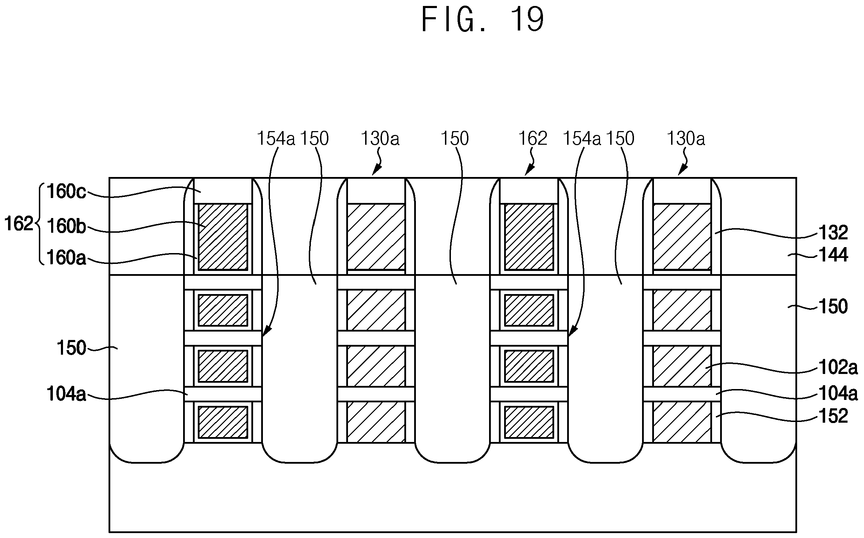

Referring to FIGS. 18 and 19, a gate structure 162 may be formed to fill the first gate trench 146 and the gaps. The gate structure 162 may extend in the second direction to cover the first nanosheet stack 154a and the second nanosheet stack.

A thermal oxidation process may be performed on surfaces of the first lower active pattern 112a and the first silicon patterns 104a exposed by the first gate trench 146 and the gaps to form an interface layer (not shown). A gate insulation layer may be formed on the interface layer. A gate electrode layer may be formed on the gate insulation layer to fill the first gate trench 146 and gaps. The gate electrode layer may include, for example, a metal material. The gate electrode layer and the gate insulation layer may be planarized and an upper surface of the insulating interlayer 144 may be exposed. Upper portions of the gate electrode layer and the gate insulation layer may be removed, and a capping pattern may be formed on an exposed portion. Therefore, gate structures 162 including an interface pattern (not shown), a gate insulating pattern 160a, a gate electrode 160b, and a capping pattern 160c may be formed to fill the first gate trench 146 and the gaps.

Through the above process, a multi-bridge channel transistor including a nanosheet stack, a gate structure, and an epitaxial pattern may be formed on the substrate 100.

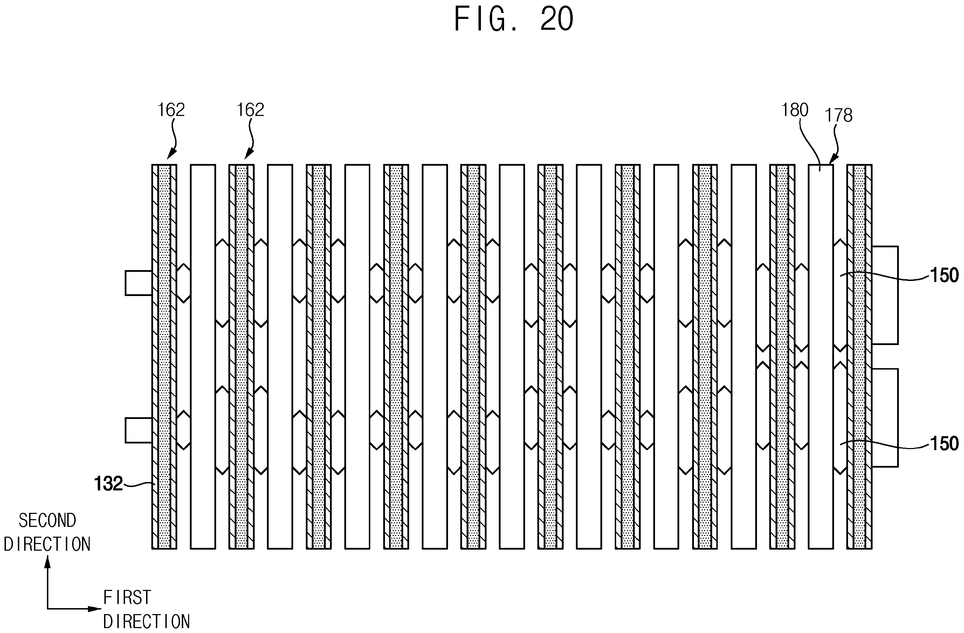

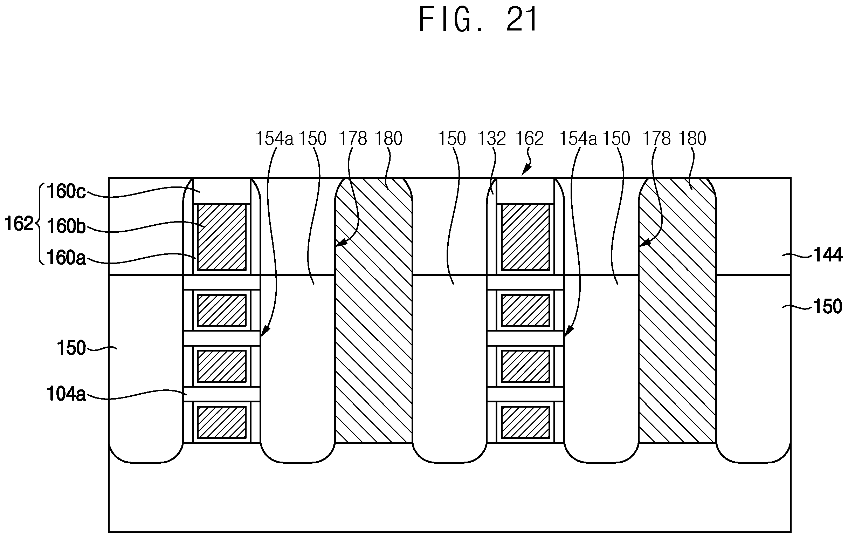

Referring to FIGS. 20 and 21, the first dummy gate structure 130a and the first spacer 132 may be removed. Subsequently, the first and second nanosheet structures, exposed by the removed portion of the first dummy gate structure 130a, and the first spacer 132 may be removed to form the third opening 178.

An insulation material may be formed to fill the third opening 178. Thus, a diffusion break pattern 180 may be formed in the third opening 178. Multi-bridge channel transistors formed on both sides of the diffusion break pattern 180 may be electrically isolated from each other by the diffusion break pattern 180.

As described above, in the plan view, the slopes of the transition regions of the first nanosheet structure 120 and the second nanosheet structure 122 may have the same angle with respect to the first direction or 0 degrees with respect to the first direction. Accordingly, the first spacers 132 may be uniformly formed on sidewalls of dummy gate structures on the transition region of the first nanosheet structure 120 and the second nanosheet structure 122, and thus defects of the multibridge channel transistor on the first nanosheet structure 120 and the second nanosheet structure 122 may decreased.

A semiconductor device manufactured by the above-described processes may have improved structural characteristics.

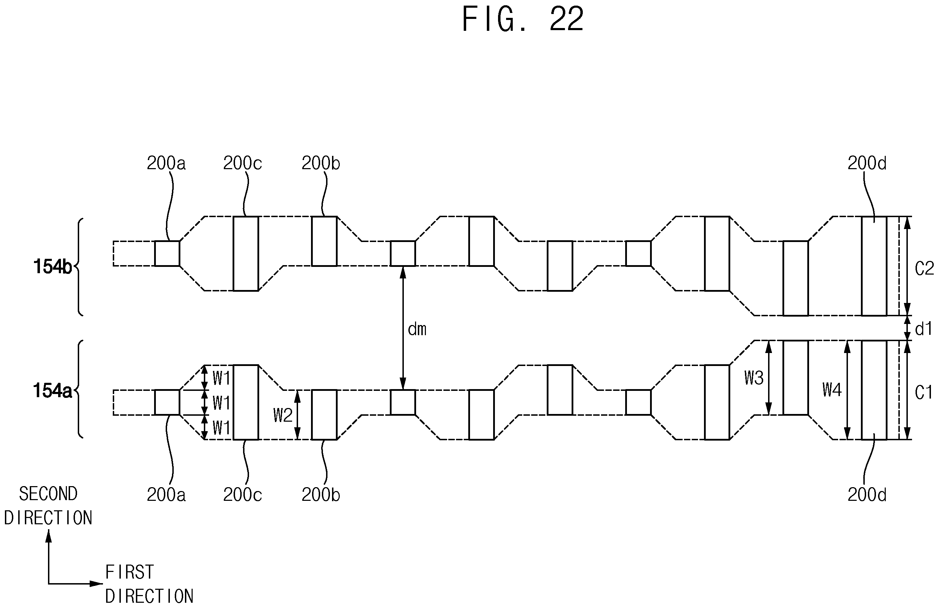

FIG. 22 is a plan view illustrating first and second nanosheet stacks in a semiconductor device.

Referring to FIGS. 20 to 22, the semiconductor device may include a first active structure including a first nanosheet stack 154a and an epitaxial pattern 150, and extending in the first direction. The semiconductor device may include a second active structure symmetrical to the first active structure with respect to the first direction. That is, the second active structure may include the second nanosheet stack 154b and the epitaxial pattern 150, and extending in the first direction.

Gate structures extending in the second direction may be formed on the first nanosheet stack 154a and the second nanosheet stack 154b.

The first nanosheet stack 154a and second nanosheet stack 154b may include nanosheets 200a, 200b, 200c, and 200d having different widths in the second direction. The nanosheets 200a, 200b, 200c, and 200d may be disposed to be spaced apart from each other in the first direction.

The first nanosheet stack 154a may include nanosheets 200a, 200b, 200c, and 200d having different widths. The width of the nanosheets 200a, 200b, 200c, and 200d may be a multiple of a minimum width of the nanosheets. For example, as shown in FIG 22, first to fourth nanosheets 200a, 200b, 200c, and 200d may be classified according to the widths of the nanosheets. The first nanosheet 200a may have a first width W1 that may be a minimum width. The second nanosheet 200b may have a second width W2 that may be twice the first width W1. The third nanosheet 200c may have a third width W3 that may be three times the first width W1. The fourth nanosheet 200d may have a fourth width W4 that may be four times the first width W1.

In the first nanosheet stack 154a, the first to fourth nanosheets 200a, 200b, 200c, and 200d may be regularly arranged in the first row region C1 of the substrate extending in the first direction.

The first row region C1 of the substrate 100 may have the same width as the maximum width of the nanosheets in the first nanosheet stack 154a. For example, the first row region C1 may have the fourth width W4.

In the plan view, the first nanosheet stack 154a may include a plurality of adjacent nanosheets, for example, including a reference nanosheet and neighboring nanosheets adjacent to the reference nanosheet. For example, one or both of the neighboring nanosheets may have a width greater than a width of the reference nanosheet. In this case, a neighboring nanosheet may protrude from at least one of an upper side and a lower side of the reference nanosheet. A width in the second direction of the protruding portion of the neighboring nanosheet(s) may have the first width W1.

In the plan view, the first nanosheet stack 154a may include a reference nanosheet and neighboring nanosheets adjacent to the reference nanosheet, and each of the nanosheets may have the same width. In example embodiments, some of the neighboring nanosheets may protrude from one of an upper side and a lower side of the reference nanosheet. A width in the second direction of the protruding portion of the neighboring nanosheet may have the first width W1. In some example embodiments, the neighboring nanosheets may not protrude from the upper side or the lower side of the reference nanosheet.

In the first nanosheet stack 154a, the width of the protruding portion of neighboring nanosheet may be the first width W1. That is, the width of the protruding portion in adjacent nanosheets may be the first width W1.

Upper and lower sides of each of the nanosheets included in the first nanosheet stack 154a may not form a straight line in the first direction. That is, when the upper sides of the adjacent nanosheets are connected to each other, the connected upper sides may not be aligned with a straight line extending in the first direction. Also, when the lower sides of the adjacent nanosheets are connected to each other, the connected lower sides may not be aligned with a straight line extending in the first direction.

The second nanosheet stack 154b and the first nanosheet stack 154a may be symmetric with respect to the first direction.

The first nanosheet stack 154a and the second nanosheet stack 154b may be disposed on at least a portion of the semiconductor device.

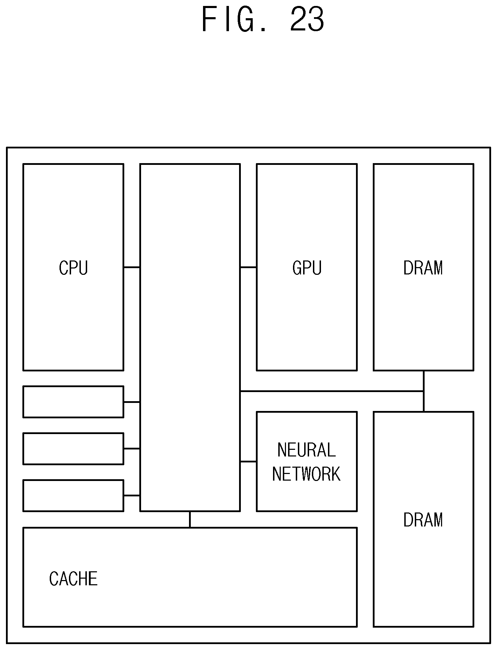

FIG. 23 is a plan view illustrating a semiconductor chip according to example embodiments.

The semiconductor chip shown in FIG. 23 may be a system-on-chip. FIG 23 shows an arrangement of elements that may be included in the system-on-chip.

Referring to FIG. 23, one chip may include block regions divided from each other. Different semiconductor system elements may be disposed in the block regions, respectively.

In example embodiments, semiconductor system elements such as a central processing unit (CPU), a DRAM memory, a neural network, a cache memory, a graphics processing unit (GPU), or the like may be disposed in each of the block regions.

Standard cells included in some block regions of the chip may include the first and second nanosheet structures as described herein. That is, portions of the first and second nanosheet structures where the active segments are adjacent to each other may have a slope of the same first angle or 0 degrees with respect to the first direction.

In example embodiments, the standard cell included in at least one of the CPU and the GPU may include the first and second nanosheet structures.

The foregoing is illustrative of example embodiments and is not to be construed as limiting thereof. Although example embodiments have been described, those skilled in the art will readily appreciate that many modifications are possible without materially departing from the novel teachings and advantages of the present inventive concept. Accordingly, all such modifications are intended to be included within the scope of the present inventive concept as defined in the claims. In the claims, means-plus-function clauses are intended to cover the structures described herein as performing the recited function and not only structural equivalents but also equivalent structures. Therefore, it is to be understood that the foregoing is illustrative of various example embodiments and is not to be construed as limited to the specific example embodiments disclosed, and that modifications to example embodiments, as well as other example embodiments, are intended to be included within the scope of the appended claims.

**Claims**

1. A semiconductor device, comprising:

   a substrate including a first row region and a second row region, wherein a surface of the substrate is disposed in a first direction and a second direction perpendicular to the first direction;
   a first nanosheet structure on the first row region, the first nanosheet structure including a plurality of active segments disposed in the first direction, and the plurality of active segments having different widths in the second direction; and
   a second nanosheet structure on the second row region, the second nanosheet structure spaced apart from the first nanosheet structure in the second direction, and wherein the second nanosheet structure is symmetrical with the first nanosheet structure in the first direction,
   wherein, in a plan view, in each of the first nanosheet structure and the second nanosheet structure, each of a plurality of transition regions between adjacent ones of the active segments have one of a first angle and a second angle with respect to the first direction.

2. The semiconductor device of claim 1, wherein the active segments included in the first nanosheet structure have widths in the second direction that are multiples of a minimum width of the active segments in the second direction.

3. The semiconductor device of claim 1, wherein the first row region has a width in the second direction equal to a maximum width of the active segments in the second direction.

4. The semiconductor device of claim 1, wherein at least one of an upper side and a lower side of at least one of the active segments included in the first nanosheet structure protrudes from an adjacent one of the active segments, and a plurality of protruding portions of the first nanosheet have a same width in the second direction.

5. The semiconductor device of claim 4, wherein the same width in the second direction of the plurality of protruding portions of the adjacent active segments is equal to a minimum width of the active segments in the second direction.

6. The semiconductor device of claim 1, wherein at least one of the active segments included in the first nanosheet structure has a different width in the second direction than an adjacent one of the active segments, and the active segments protrudes from one of an upper side and a lower side of the adjacent one of the active segments in the second direction.

7. The semiconductor device of claim 1, wherein a first one and a second one of the active segments included in the first nanosheet structure are adjacent, have a same width in the second direction, and are unaligned in the second direction, wherein the transition region between the first one and the second one of the active segments has the first angle with respect to the first direction.

8. The semiconductor device of claim 1, wherein a first one and a second one of the active segments included in the first nanosheet structure are adjacent, have a same width in the second direction, and are aligned in the first direction, wherein the transition region between the first one and the second one of the active segments has the second angle with respect to the first direction, wherein the second angle is 0 degrees.

9. The semiconductor device of claim 1, wherein a maximum distance in the second direction between the first nanosheet structure and the second nanosheet structure is equal to or less than a sum of twice a difference between a maximum width and a minimum width of the active segments and a first distance between the first row region and the second row region.

10. The semiconductor device of claim 1, wherein a diffusion break pattern extending in the second direction is formed at a contacting portion of the active segments included in the first nanosheet structure and the second nanosheet structures.

11. The semiconductor device of claim 1, further comprising semiconductor system elements disposed in a plurality of block regions,

wherein a standard cell included in at least one of the block regions includes the first nanosheet structure and the second nanosheet structure.

12. A semiconductor device, comprising:

a substrate including a surface disposed in a first direction and a second direction perpendicular to the first direction;
a first nanosheet structure on the substrate, the first nanosheet structure including first active segments disposed in the first direction, and the first active segments having different widths in the second direction;
a second nanosheet structure on the substrate, the second nanosheet structure including second active segments in the first direction and spaced apart from the first nanosheet structure in the second direction, and wherein the second nanosheet structure is symmetrical with the first nanosheet structure in the first direction;
a diffusion break pattern extending in the second direction, the diffusion break pattern on contacting portions between the first active segments and the second active segments; and
a gate structure extending in the second direction, the gate structure in a region between the diffusion break patterns;
wherein a plurality of protruding portions of the active segments included in the first nanosheet structure have a same width in the second direction.

13. The semiconductor device of claim 12, wherein the width of the protruding portions is equal to a minimum width of the active segments.

14. The semiconductor device of claim 12, wherein the first nanosheet structure is formed on the substrate in a first row region, and

wherein the first row region has a width in the second direction is equal to a maximum width of the active segments in the second direction.
wherein all the plurality of protruding portions of the active segments included in the first nanosheet structure have the same width.

15. The semiconductor device of claim 12, wherein at least an upper side and a lower side of two of the active segments of the first nanosheet structure is aligned with the first direction.

# FIG. 1

# FIG. 2

EP 4 350 752 A2

SECOND
DIRECTION

FIRST
DIRECTION

# FIG. 3

# FIG. 4

EP 4 350 752 A2

# FIG. 5

# FIG. 6

# FIG. 7

EP 4 350 752 A2

SECOND
DIRECTION

FIRST
DIRECTION

# FIG. 8

# FIG. 9

EP 4 350 752 A2

104

104
102

100

THIRD
DIRECTION

SECOND
DIRECTION

FIRST
DIRECTION

# FIG. 10

EP 4 350 752 A2

# FIG. 11

SECOND
DIRECTION

FIRST
DIRECTION

# FIG. 12

THIRD
DIRECTION

SECOND
DIRECTION

FIRST
DIRECTION

EP 4 350 752 A2

EP 4 350 752 A2

# FIG. 13

130b 130a 130b 130a  ...  130a 130b 130a 130b

122

120

**132**

SECOND
DIRECTION

FIRST
DIRECTION

# FIG. 14

EP 4 350 752 A2

FIG. 15

# FIG. 16

SECOND
DIRECTION

FIRST
DIRECTION

FIG. 17

132
144
150
104a
102a
152

130a
150
146
150
130a
150
146

154a
154a

142a
150
104a
148

# FIG. 18

EP 4 350 752 A2

# FIG. 19

EP 4 350 752 A2

# FIG. 20

EP 4 350 752 A2

# FIG. 21

EP 4 350 752 A2

# FIG. 22

EP 4 350 752 A2

# FIG. 23

**REFERENCES CITED IN THE DESCRIPTION**

**Patent documents cited in the description**

- KR 1020220128679